# NEUE EUROPÄISCHE PATENTSCHRIFT

(11) **EP 0 317 787 B2**
(45) Veröffentlichungstag und Bekanntmachung des Hinweises auf die Entscheidung über den Einspruch: **07.05.1997**
(45) Hinweis auf die Patenterteilung: 02.03.1994
(21) Anmeldenummer: 88117965.9
(22) Anmeldetag: 28.10.1988
(51) Int. Cl.: H02K 41/035

(54) **Einrichtung zur Durchführung der Zustellbewegung eines Arbeitsorgans zu einer Arbeitsstation**
Device for carrying out the readying movement of a work piece towards a work station
Dispositif pour l'exécution du mouvement d'un organe de travail vers un poste de travail

(30) Priorität: 25.11.1987 CH 4579/87
(43) Veröffentlichungstag der Anmeldung: 31.05.1989
(73) Patentinhaber: ESEC SA, CH-6330 Cham (CH)
(72) Erfinder: Meisser, Claudio, CH-6330 Cham (CH); Eggenschwiler, Hans, CH-6312 Steinhausen (CH); Nehls, Walter, CH-6312 Steinhausen (CH)
(74) Vertreter: EGLI-EUROPEAN PATENT ATTORNEYS

(56) Entgegenhaltungen:
- EP-B- 0 121 829
- DE-C- 1 911 908
- FR-A- 2 032 170
- FR-A- 2 262 849
- FR-A- 2 442 537
- US-A- 4 654 571
- Prospekt der Wyler AG, Wasserwaagen und Werkzeugfabrik, Im Hölderli, CH-8405 Winterthur, mit dem Titel "Der Messrobot, der es mit jedem anderen aufnimmt..... ."

## Beschreibung

Die Erfindung betrifft eine Einrichtung zur Durchführung der Zustellbewegung eines Arbeitsorgans, insbesondere eines Bondkopfes zu einer Arbeitsstation.

Aus der DE-PS 22 44 442 ist eine im wesentlichen mit elektrischen Mitteln betätigbare Einstellvorrichtung bekannt, welche ein Ständerglied sowie ein Läuferglied umfasst. Die dem Läuferglied zugewandte Fläche des Ständerglieds ist hierbei in Bezirke aufgeteilt, von den jeder Bezirk parallel zueinander verlaufende Rippen aus magnetisierbarem Material aufweist. An der Unterseite des Läufergliedes sind mit den genannten Bezirken zusammenwirkende, elektromagnetische Mittel derart angeordnet, dass bei Erregung der elektromagnetischen Mittel eine Bewegung des Läufergliedes in X- oder Y-Richtung erfolgen kann. Zwischen dem Läuferglied und dem Ständerglied kann weiterhin ein Luftzwischenraum vorgesehen sein, so dass das als Kopfstück ausgebildete Läuferglied im wesentlichen auf einem Luftkissen über dem als Platte ausgebildeten Ständerglied schwebt.

Aus der US-A 4 654 571 ist eine Einrichtung bekannt, welche im wesentlichen eine zur Aufnahme eines kreisscheibenförmigen Halbleiterelementes ausgebildete Plattform umfaßt. Die Plattform ist mittels drei im Abstand zueinander angeordneter und als Luftlager ausgebildeter Ausleger auf einer ebenen Platte gelagert. Das auf der Plattform liegende Halbleiterelement wird hierbei von einem zugeordneten Phototeil über eine Photomaske entsprechend belichtet. Die Platte ist auf der der Plattform zugewandten Seite mit weitgehend über die gesamte Fläche verteilt angeordneten, magnetischen Elementen und die Plattform auf der der Platte bzw. der magnetischen Element zugewandten Seite mit vier symmetrisch zur vertikalen Achse der Plattform angeordneten Spulenkörpern versehen. Mittels der Magnet- und Spulenelement ist bei entsprechender Erregung die Plattform in X- und Y-Richtung in der Ebene relativ zu der Platte verstellbar. Die Luftlagerung geschieht entsprechend der US-A 4 654 571 ausschliesslich durch aus einem kreuzförmigen Schlitz austretende Druckluft. Hierdurch ist jedoch keine exakte Luftlagerung möglich. Ferner kann durch eine schachbrettförmige Anordnung von Magnetelementen, welche mit entsprechenden Spulen in einem Körper zusammenwirken, niemals die Genauigkeit der Bewegung eines Arbeitselementes erreicht werden, wie dies für eine gattungsgemässe Zustellvorrichtung erforderlich ist.

Aus dem Prospekt "Der Messrobot, der es mit jedem anderen aufnimmt..." der Fa. Wyler AG, Wasserwagen- und Werkzeugfabrik in Winterthur, der mit Kundenschreiben vom 29.10.84 zur Messe Microtecnic 84 kekannt wurde, geht ein Messroboter mit drei relativ zueinander bewegbaren Schlitten aus Stein hervor. Die Schlitten werden über spezielle Luftlager geführt, bei denen mittels eines Ueberdrucks in drei sich verwundenen Spiralen ein Luftkissen gebildet wird und ein umschliessender Vakuumring die Haftung übernimmt. Eine Gleitplatte ist jedoch nicht vorgesehen.

Aus der EP-0 121 829-B1 ist ferner ein Lagerkörper für Luftlagerungen bekannt. Dieser Lagerkörper weist eine zentral in eine Lagerfläche mündende Luftzuführöffnung und mehrere, von der Luftzuführöffnung spiralförmig in der Lagerfläche nach aussen verlaufende, sich um einen Winkel von mehr als 360° erstreckende Luftführungskanäle auf. Dadurch wird eine gleichmässige Luftverteilung im Luftspalt zwischen den Lagerflächen des Luftlagers erreicht. Konzentrisch zur Luftzuführöffnung ist zur Stabilisierung des Lagers eine die Lagerfläche kanalförmig umschliessende, an einer Unterdruckquelle anschliessbare Luftabführungsöffnung vorgesehen.

Schliesslich beschreibt die DE-1 911 908-C eine Einrichtung zum messbaren Verschieben eines auf einem Objektträger angeordneten Objektes in zwei senkrecht zueinander stehende Richtungen, bei der die Führungsleisten des Objektträgers in unabhängig voneinander beweglichen Geradführungen gelagert sind, welche an voneinander getrennt gelagerten Schlitten angeordnet sind. Der Objektträger ist über aerostatische, auf der Grundplatte laufende Stützlager in der Messebene geführt.

Eine Aufgabe der Erfindung ist darauf gerichtet, eine Einrichtung zu schaffen, die mit einfachen Mitteln eine gegen vertikal am Trägerelement wirkende Kräfte gesicherte, hochdynamische und exakte Zustellbewegung des mit einem Arbeitsorgan versehenen Trägerelements zu der Arbeitsstation ermöglicht.

Erfindungsgemäss wird diese Aufgabe durch die Merkmale von Anspruch 1 gelöst.

Ausführungsbeispiele sowie zweckmässige Ausgestaltungen ergeben sich aus der folgenden Beschreibung in Verbindung mit der Zeichnung und den einzelnen Patentansprüchen.

Die Erfindung wird nachstehend anhand der Zeichnungen beschrieben. Es zeigt:
- Fig. 1: ein erstes, schematisch dargestelltes Ausführungsbeispiel einer Einrichtung zur Durchführung einer Zustellbewegung eines Arbeitsorgans zu einer Arbeitsstation;
- Fig. 2: ein zweites, schematisch dargestelltes Ausführungsbeispiel der Einrichtung zur Durchführung der Zustellbewegung des Arbeitsorgans;
- Fig. 4: die in grösserem Massstab und in perspektivischer-Ansicht dargestellte Einrichtung gemäss Fig.1,
- Fig. 5: eine gemäss Pfeilrichtung V in Fig.4 schematisch dargestellte Unterseite eines Trägerelements für das Arbeitsorgan,
- Fig. 6: eine im Schnitt gemäss der Linie VI-VI in Fig.4 dargestellte Führungsvorrichtung für die Einrichtung gemäss Fig.1,
- Fig. 7: eine gemäss Pfeilrichtung VII in Fig.4 schematisch dargestellte Unteransicht eines Führungsteils für die Einrichtung gemäss Fig.1,
- Fig. 8: eine gemäss Pfeilrichtung VIII in Fig.4 schematisch dargestellte Vorderansicht des Führungsteils für die Einrichtung gemäss Fig.1,
- Fig. 9: eine schematisch dargestellte erste Variante der Führungsvorrichtung für die Einrichtung gemäss Fig.1,
- Fig.10: eine schematisch dargestellte zweite Variante der Führungsvorrichtung für die Einrichtung gemäss Fig.1,
- Fig.11: einen Schnitt gemäss der Linie XI-XI durch die Führungsvorrichtung gemäss Fig.10,
- Fig.12: eine schematisch dargestellte Mess-Vorrichtung für die Einrichtung gemäss Fig.1 und Fig.4.

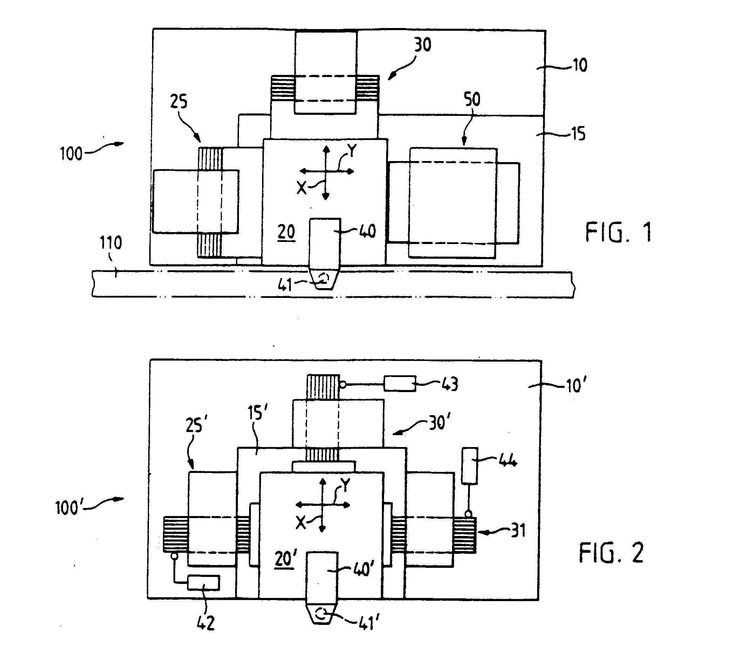

In den Figuren 1 und 2 ist zur Verdeutlichung der Erfindung als allgemeine System-übersicht jeweils eine in ihrer Gesamtheit mit 100 oder 100' bezeichnete Einrichtung schematisch dargestellt, welche zur Durchführung einer Zustellbewegung eines Arbeitsorgans (in den Figuren 1 und 2 nicht dargestellt) zu einer Arbeitsstation ausgebildet ist. Die Zustellbewegung des Arbeitsorgans zu einem entsprechend zugeordneten Transportband 110 (nur in Fig.1 dargestellt) oder dergleichen erfolgt hierbei etwa längs zweier, in der Ebene etwa rechtwinklig zueinander orientierter Koordinaten in X-und/oder Y-Richtung.

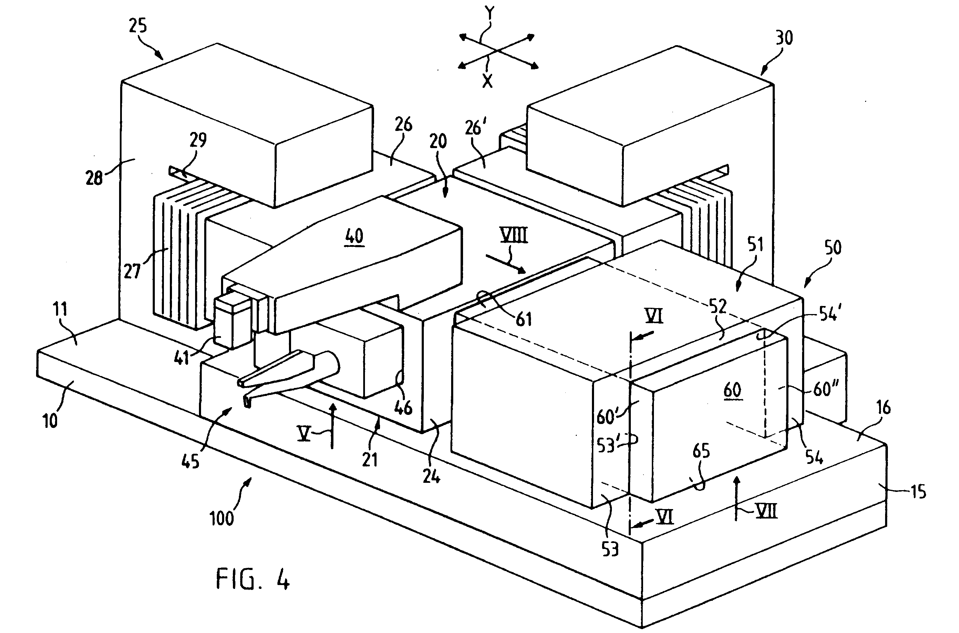

Die Einrichtung 100 gemäss Fig.1 umfasst im wesentlichen eine Grundplatte 10, eine Gleitplatte 15, ein Trägerelement 20 für das nicht näher dargestellte Arbeitsorgan, einen ersten Antrieb 25 für eine in Y-Richtung und einen zweiten Antrieb 30 für eine in X-Richtung orientierte Zustellbewegung des Trägerelements 20 sowie eine mit dem Trägerelement 20 in Wirkverbindung stehende Führungsvorrichtung 50. Das Trägerelement 20 ist zur Aufnahme des Arbeitsorgans (Teil 45 in Fig.4) und eines Auslegers 40 ausgebildet. An der dem Transportband 110 zugewandten Seite ist an dem Ausleger 40 weiterhin ein optisches Abtastelement 41 (Sensor) vorgesehen.

Die Einrichtung 100' gemäss Fig.2 umfasst im wesentlichen eine Grundplatte 10', eine Gleitplatte 15', ein Trägerelement 20' mit Ausleger 40' und Abtastelement 41', einen ersten Antrieb 25' für die in X-Richtung und einen zweiten Antrieb 30' für die in Y-Richtung orientierte Zustellbewegung. Abweichend von der Einrichtung 100 gemäss Fig.1 ist bei der Einrichtung 100' anstelle der Führungsvorrichtung 50 ein weiterer, korrespondierend zu dem ersten Antrieb 25' angeordneter dritter Antrieb 31 vorgesehen. Weiterhin erkennt man in Fig.2 den Antrieben 25' und 30'sowie 31 zugeordnete Messorgane 42,43 und 44, welche Messorgane für eine Abstandsmessung sowie für eine Parallelitätsmessung und Regelung ausgebildet und entsprechend angeordnet sind.

Bei den vorstehend beschriebenen Ausführungsbeispielen der Einrichtung 100 und 100' gemäss Figur 1 und 2 ist das jeweilige Trägerelement 20,20' mittels einem vakuumvorspannbaren Luftkissenlager 1, welches nachstehend als Luftlager 1 bezeichnet ist, gegen vertikale Kräfte gesichert an der Gleitplatte 15,15' in der Ebene in
X- und /oder Y-Richtung frei beweglich gelagert.
Fig.4 zeigt als bevorzugtes Ausführungsbeispiel die in grösserem Massstab und in perspektivischer Ansicht dargestellte Einrichtung 100 und man erkennt die Grundplatte 10, die Gleitplatte 15, das Trägerelement 20 mit dem Ausleger 40, die beiden Antriebe 25 und 30 sowie die Führungsvorrichtung 50.

Die Grundplatte 10 hat eine absolut ebene Montagefläche 11, welche als Auflage- und Befestigungsfläche für die beiden Antriebe 25,30 sowie für die Gleitplatte 15 vorgesehen und entsprechend ausgebildet ist.

Die Gleitplatte 15 ist mit nicht näher dargestellten Mitteln auf der Grundplatte 10 befestigt und ist auf der dem Trägerelement 20 und der Führungsvorrichtung 50 zugewandten Seite mit einer ebenen Gleitfläche 16 versehen. Die Gleitfläche 16 hat zur Bildung eines sogenannten Luftlagers eine entsprechend ausgebildete, vorzugsweise geschliffene Oberflächenstruktur. Die Grundplatte 10 sowie die Gleitplatte 15 können unter Beibehaltung der entsprechenden Auflage-, Befestigungs- und Gleitflächen auch als eine Baueinheit einstückig ausgebildet sein.

Das Trägerelement 20 ist vorzugsweise als kastenförmiger Hohlkörper mit einer Ausnehmung 46 zur Aufnahme und Befestigung des Arbeitsorgans 45, beispielsweise zur Aufnahme eines für die Halbleitertechnik entsprechend ausgebildeten Greiferorgans 45 ausgebildet. An der mit 21 bezeichneten Unterseite des Trägerelements 20 ist zur Kompensation vertikal am Trägerelement 20 wirkender Kräfte ein vakuumvorspannbares Luftlager 1 angeordnet.

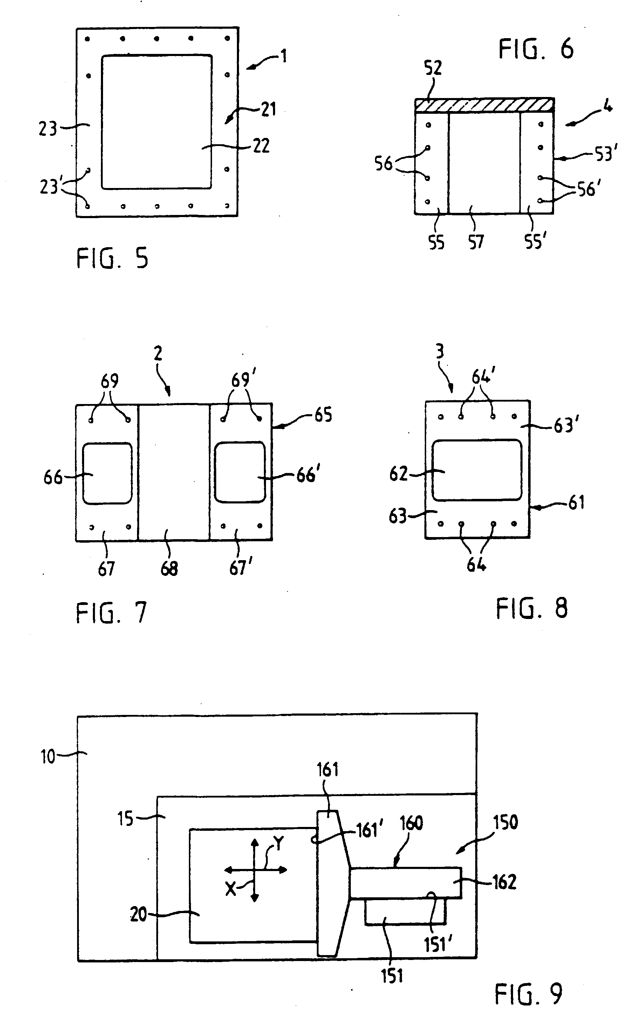

Fig.5 zeigt gemäss Pfeilrichtung V in Fig.4 das an der Unterseite 21 des Trägerelements 20 angeordnete Luftlager 1 und man erkennt eine als Vertiefung oder Ausnehmung ausgebildete Vakuumzone 22, welche vollumfänglich von einer mit im Abstand zueinander angeordneten Bohrungen 23' oder dergleichen versehenen Druckluftzone 23 umgeben ist.

Die Führungsvorrichtung 50 umfasst ein Führungsteil 51 sowie ein Schiebeteil 60. Das im Profilquerschnitt U-förmig ausgebildete Führungsteil 51 hat zwei etwa parallel zueinander angeordnete und durch einen Flansch 52 miteinander verbundene Stege 53,54. Das Führungsteil 51 ist mit den beiden Stegen 53,54 auf der Gleitfläche 16 der Gleitplatte 15 angeordnet und mit nicht näher dargestellten Befestigungsmitteln lösbar befestigt. Die beiden dem Schiebeteil 60 zugewandten Innenseiten 53' und 54' der Stege 53,54 sind als Gegendrucklager 4 ausgebildet.

Fig.6 zeigt im Schnitt gemäss der Linie VI-VI in Fig.4 als Ausführungsbeispiel das Führungsteil 51 mit dem an der einen Innenseite 53' angeordnete Gegendrucklager 4 und man erkennt zwei durch eine Vertiefung oder Ausnehmung 57 im Abstand zueinander angeordnete und getrennte Druckluftzonen 55,55', welche mit im Abstand zueinander angeordneten Bohrungen 56,56' versehen sind.

Das im wesentlichen quaderförmig ausgebildete Schiebeteil 60 ist einerseits auf der der Seitenwand 24 des Trägerelements 20 zugewandten Stirnseite 61 mit einem Luftlager 3 und andererseits auf der der Gleitfläche 16 der Gleitplatte 15 zugewandten Unterseite 65 mit einem Luftlager 2 versehen.

Fig.7 zeigt gemäss Pfeilrichtung VII in Fig.4 das an der Unterseite 65 des Schiebeteils 60 angeordnete Luftlager 2 und man erkennt zwei durch eine Ausnehmung oder Vertiefung 68 im Abstand zueinander angeordnete Druckluftzonen 67,67', in welchen jeweils eine als Ausnehmung oder Vertiefung ausgebildete Vakuumzone 66,66' angeordnet ist. In den einzelnen Druckluftzonen 67,67' sind entsprechend im Abstand zueinander angeordnete Bohrungen 69,69' vorgesehen.

Fig.8 zeigt gemäss Pfeilrichtung VIII in Fig.4 das an der Stirnseite 61 des Schiebeteils 60 angeordnete Luftlager 3 und man erkennt eine als Ausnehmung oder Vertiefung ausgebildete Vakuumzone 62 sowie eine die Vakuumzone 62 umgebende Druckluftzone 63,63' mit im Abstand zueinander angeordneten Bohrungen 64, 64'.

An dieser Stelle sei darauf hingewiesen, dass das an der Unterseite 21 des Trägerelements 20 angeordnete Luftlager 1 (Fig.5) und das an der Unterseite 65 des Schiebeteils 60 angeordnete Luftlager 2 (Fig.7) sowie das an der Stirnseite 61 des Schiebeteils 60 angeordnete Luftlager 3 (Fig.8) jeweils als ein vakuumvorspannbares Luftlager ausgebildet ist, während das den beiden Seitenflächen 60',60" des Schiebeteils 60 zugeordnete und an den Innenseiten 53',54' der Stege 53,54 angeordnete Luftlager 4 (Fig.6) vorzugsweise als ein sogenanntes Gegendrucklager ausgebildet ist. Die einzelnen Luft-lager 1,2,3 und 4 sind zur Erzeugung des erwähnten Vakuums oder für die Druckluftzufuhr über ein nicht näher dargestelltes und in den einzelnen Elementen angeordnetes Kanalsystem mit einer entsprechenden Energiequelle wirkverbunden.

Die beiden elektromotorischen ausgebildeten Antriebe 25 und 30 gemäss Fig.4 sind in ihrem konstruktiven Aufbau sowie in ihrer Funktionsweise miteinander identisch. An dieser Stelle werden lediglich die wesentlichen Elemente des einen Antriebs 25 beschrieben:

Der Antrieb 25 umfasst einen mit Magneten (nicht dargestellt) versehenen Statorkörper 28, einen in entsprechend ausgebildeten Schlitzen 29 (nur ein Schlitz dargestellt) des Statorkörpers 28 angeordneten Spulenkörper 27, welcher an einem Trägerglied 26 angeordnet ist.

Der Statorkörper 28 hat mindestens zwei in parallelem Abstand zueinander angeordnete Schlitze 29 und ist mit nicht näher dargestellten Mitteln an der Oberfläche 11 der Grundplatte 10 angeordnet, vorzugsweise lösbar befestigt.

Das Trägerglied 26 ist zur Aufnahme des Spulenkörpers 27 ausgebildet und mit nicht näher dargestellten Mitteln an dem Trägerelement 20 lösbar befestigt. Zur Aufnahme eines nicht bezeichneten Spulenkörpers für den Antrieb 30 ist an dem Trägerelement 20 ein weiteres Trägerglied 26' vorgesehen. Die einzelnen, nicht näher bezeichneten Elemente des Antriebs 30 sind mit den Elementen 27,28 und 29 des Antriebs 25 identisch.

Die einzelnen Teile der elektromotorischen Antriebe 25 und 30 gemäss Fig.1 und Fig.4 sowie die Teile 25',30',31 gemäss Fig.2 sind derart ausgebildet und zueinander angeordnet, dass bei entsprechender Gleichstrom- oder Gleichstrompuls-Erregung des Spulenkörpers 27 eine horizontale Hubbewegung der miteinander wirkverbundenen Teile 27,26 und 20 relativ zu dem Statorkörper 28 in X- und/oder Y-Richtung erzeugt wird. Aufgrund der besonderen Ausbildung und Anordnung der Teile 26 und 27 in den Schlitzen 29 des Statorkörpers 28 kann zusätzlich zu der im wesentlichen linearen Bewegung in X- oder Y-Richtung auch eine etwa quer dazu, d.h., eine etwa parallel zum Windungsverlauf des Spulenkörpers 27 orientierte Bewegung erzeugt werden. Diese sogenannte ergiebige Querbewegung ist abhängig von den Innenmassen der beispielsweise kastenrahmenartig ausgebildeten Teile 26,27 in bezug zu dem Aussenmass des, von den Teilen 26,27 vollumfänglich umgebenen, nicht näher dargestellten und bezeichneten mittleren Flansches des Statorkörpers 28.
Bei dem in Fig.4 dargestellten Ausführungsbeispiel des elektromotorischen Antriebs 25 ist das Trägerglied 26 für den Spulenkörper 27 starr mit dem Trägerelement 20 verbunden und bildet eine relativ zu dem feststehenden Statorkörper 28 in horizontaler Ebene weitgehend frei bewegliche, schwebende Baueinheit. Das Trägerglied 26 ist hierbei derart an dem Trägerelement 20 angeordnet und mit nicht dargestellten Mitteln befestigt, dass der auf das Trägerelement 20 wirkende Kraftfluss im wesentlichen durch den Schwerpunkt des Trägerelements 20 verläuft. Das Trägerelement 20 zusammen mit dem Spulenkörper 27 und dem Trägerglied 26 sind hierbei relativ zu dem feststehenden Statorkörper 28 in eine erste Richtung, welche mit der Spulenachse (nicht bezeichnet) etwa gleichsinnig verläuft, sowie in eine zweite, etwa rechtwinklig dazu orientierte Richtung bewegbar. Der elektromotorische Antrieb 30 ist analog dem Antrieb 25 ausgebildet.
Bei einer nicht dargestellten Variante der elektromotorischen Antriebe besteht jedoch auch die Möglichkeit, den Statorkörper 28 und das Trägerelement 20 oder 20' als eine Baueinheit auszubilden und das Trägerglied 26 mit dem Spulenkörper 27 feststehend auszubilden und anzuordnen. Hierbei ist das Trägerelement 20,20' zusammen mit dem Statorkörper relativ zu einem feststehend angeordneten Trägerglied für den Spulenkörper in eine die erste, mit der Spulenachse etwa gleichsinnig verlaufenden Richtung, sowie in die zweite, etwa rechtwinklig dazu orientierte Richtung bewegbar.

An dieser Stelle sei darauf hingewiesen, dass die in den Figuren 1,2 und 4 schematisch dargestellten Antriebe 25,25' und 30,30' sowie 31 in ihrem speziellen, konstruktiven Aufbau sowie in ihrer Wirkungsweise nicht Gegenstand dieser Erfindung sind und deshalb hier nicht näher beschrieben werden.

Fig.9 zeigt eine schematisch dargestellte Variante einer Führungsvorrichtung 150 für die in Fig.1 dargestellte Einrichtung 100, und man erkennt die Grundplatte 10 mit der darauf angeordneten Gleitplatte 15 sowie das auf der Gleitplatte in X- und/oder Y-Richtung verstellbare und mit den hier nicht dargestellten Antrieben wirkverbundene Trägerelement 20. Das Trägerelement 20 ist ebenfalls mittels dem in Fig.5 dargestellten, vakuumvorspannbaren Luftlager 1 auf der Gleitplatte 15 frei beweglich verstellbar angeordnet. Die Führungsvorrichtung 150 umfasst ein mit einem Flansch 161 und einem etwa quer dazu angeordneten Steg 162 im Querschnitt T-förmig ausgebildetes Schiebeteil 160, welches mit dem Steg 162 an einem balkenartig ausgebildeten Führungsteil 151 geführt ist. Das Führungsteil 151 ist mit nicht dargestellten Mitteln an der Oberfläche der Gleitplatte 15 lösbar befestigt. Die dem Trägerelement 20 zugewandte, vertikal orientierte Flanschfläche 161' sowie die dem Steg 162 zugewandte, vertikal orientierte Führungsfläche 151' sind jeweils mit einem vakuumvorspannbaren Luftlager 3, wie beispielsweise in Fig.8 dargestellt, versehen.

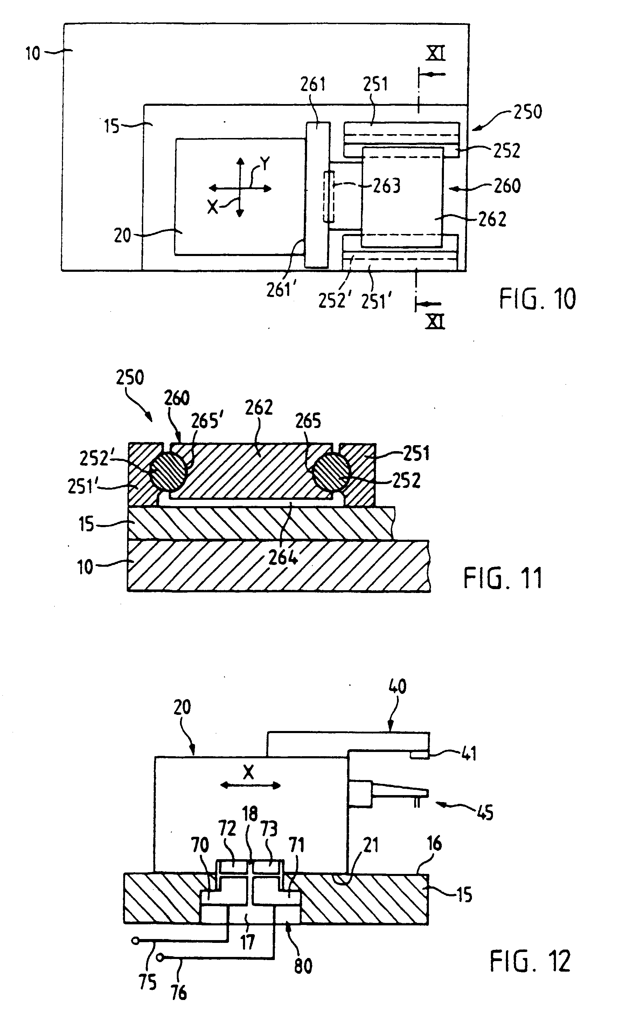

Fig.10 zeigt eine weitere, schematisch dargestellte Variante einer mit 250 bezeichneten Führungsvorrichtung für das Trägerelement 20 der Einrichtung 100 gemäss Fig.1, und man erkennt die Grundplatte 10, die Gleitplatte 15 sowie das gegen vertikale Kräfte mittels dem in Fig.5 dargestellten Luftlager 1 vakuumvorgespannt auf der Gleitplatte 15 verstellbare Trägerelement 20 für den hier nicht dargestellten Bondkopf. Die Führungsvorrichtung 250 umfasst ein aus einem balkenartigen Flansch 261 und einem plattenartigen Steg 262 im wesentlichen zweiteilig ausgebildetes Schiebeteil 260. Der Steg 262 ist mittels einem an den Teilen 261 und 262 integrierten und federelastisch wirkenden Blechstreifen 263 mit dem Flansch 261 wirkverbunden. Das Schiebeteil 260 ist, wie in Fig.11 im Schnitt gemäss der Linie XI-XI in Fig.10 dargestellt, in zwei seitlich auf der Gleitplatte 15 angeordneten Führungsteilen 251,251' gehalten und mit geringem Spalt 264 im Abstand zu der Gleitplatte 15 angeordnet. Die dem Trägerelement 20 zugewandte, vertikale Flanschfläche 261' ist mit einem vakuumvorspannbaren Luftlager 3, wie beispielsweise in Fig.8 dargestellt, versehen. Zwischen den beiden Führungsteilen 251,251' und dem Steg 262 ist als Verbindungselement jeweils ein Profilkörper, im dargestellten Beispiel ein zylindrischer Profilkörper 252,252' vorgesehen, wobei die Teile 251,251' sowie der Steg 262 mit entsprechend dem Profilkörper ausgebildeten Ausnehmungen versehen ist. Zwischen der Aussenfläche des einzelnen Profilkörpers 252,252' und der Ausnehmung im Steg 262 des Schiebeteiles 260 ist jeweils ein nicht näher dargestelltes Luftlager 265,265' vorgesehen.

Zum Erfassen der momentanen Stellung des Trägerelements 20,20' und zur entsprechenden Steuerung beziehungsweise Betätigung der zugeordneten elektromotorischen Antriebe 25,30 oder 25',30',31 oder 32,32' sind an den Einrichtungen 100,100' entsprechend ausgebildete Messorgane vorgesehen und angeordnet, mittels welchen in Abhängigkeit eines Ergebnisses, beispielsweise eines Vergleichs-Ergebnisses der jeweilige in X- oder Y-Richtung wirkende Antrieb betätigt, beispielsweise von einem Gleichstrom-Erregungsimpuls betätigt wird.

Bei dem bevorzugten Ausführungsbeispiel der Einrichtung 100 gemäss Fig.1 beziehungsweise Fig.4 sind in dem Trägerelement 20, wie in Fig.12 schematisch dargestellt, auf der der Gleitplatte 15 zugewandten Unterseite 21 in einer entsprechend ausgebildeten Ausnehmung 18 zwei Messelemente 72,73 angeordnet und mit nicht näher dargestellten Mitteln lösbar befestigt. In einer Ausnehmung 17 der Gleitplatte 15 sind zwei den Messelementen 72,73 zugeordnete Messköpfe 70 und 71 angeordnet und mit nicht dargestellten Mitteln befestigt. Die einzelnen Elemente 70 bis 75 bilden zusammen eine optronische Mess-Vorrichtung 80. Als Messelemente 72,73 können beispielsweise sogenannte Glas-Massstäbe vorgesehen sein, von welchen der eine mit in X-Richtung und der andere mit in Y-Richtung orientierten Stricheinheiten versehen ist. Als Messelement kann auch eine einstückig ausgebildete, mit in X- und Y-Richtung orientierten Stricheinheiten versehene Platte oder dergleichen in die Ausnehmung 18 eingebaut oder an geeigneter Stelle des Trägerelements 20 angeordnet werden. Mittels der vorzugsweise optronisch arbeitenden Messköpfe 70,71 werden von den am Trägerelement 20 angeordneten Messelementen 72,73 stellungsabhängige Daten ermittelt und in Signale umgewandelt, welche über Leitungen 74,75 beispielsweise den elektromotorischen Antrieben 25,30 oder aber einer die Antriebe 25,30 entsprechend betätigende Steuereinrichtung (nicht dargestellt) zugeführt werden.

## Patentansprüche

1. Einrichtung zur Durchführung der Zustellbewegung eines Arbeitsorgans, insbesondere eines als Greifer ausgebildeten Bondkopfes zu einer Arbeitsstation, mit einem zur Aufnahme des Arbeitsorganes ausgebildeten und auf einer Gleitplatte (15, 15') angeordneten Trägerelement (20, 20'), das mit mindestens zwei Antrieben (25, 30), beispielsweise mit elektromotorischen Antrieben, wirkverbunden und relativ zu der Gleitplatte (15, 15') längs zweier, in der Ebene etwa rechtwinklig zueinander orientierter Koordinaten in X- und Y-Richtung verstellbar ist, wobei das Trägerelement (20, 20') im wesentlichen mit dem sich bewegenden Teil des elektromotorischen Antriebes wirkverbunden und mittels einem der Gleitplatte (15, 15') zugeordneten Gleitlager in vorgegebener, horizontaler Ebene mit Translationsfreiheitsgraden und Rotationsfreiheitsgrad beweglich und weitgehend frei schwebend an der Gleitplatte (15, 15') angeordnet ist, dadurch gekennzeichnet, dass der Rotationsfreiheitsgrad senkrecht zur XY-Ebene dadurch erzielt wird, dass die beweglichen Teile der Antriebe und das Trägerelement (20, 20') quer zur jeweiligen Antriebsrichtung (X, respektive Y) in eine zweite etwa rechtwinklig verlaufende Richtung (Y, respektive X) bewegbar ist, und dass mindestens ein an der der Gleitplatte (15, 15') zugewandten Unterseite (21) angeordnetes und aus einer Vakuumzone (22) sowie einer die Vakuumzone (22) umschliessenden Druckluftzone (23) gebildetes Luftkissenlager (1) vakuumvorgespannt auf der Gleitplatte (15, 15') angeordnet ist.

2. Einrichtung nach Anspruch 1, dadurch gekennzeichnet, dass das Trägerelement (20) mit einem ersten Antrieb (25) für die in Y-Richtung orientierte Bewegung, mit einem zweiten Antrieb (30) für die in X-Richtung orientierte Bewegung und auf der dem ersten Antrieb (25) gegenüberliegenden Seite mit einer Führungsvorrichtung (50,150,250) sowie mit einer dem Trägerelement (20) entsprechend zugeordneten, optronischen Mess-Vorrichtung (80) wirkverbunden ist, wobei die Mess-Vorrichtung (80) zum Erfassen der relativ zur Gleitplatte (15) in X- und /oder Y-Richtung orientierten Bewegung des Trägerelements (20) sowie zur Betätigung einer Steuerung der beiden Antriebe (25,30) ausgebildet ist (Fig,1,12).

3. Einrichtung nach Anspruch 1, dadurch gekennzeichnet, dass dem Trägerelement (20') für die in X-Richtung orientierte Bewegung zwei korrespondierend zueinander angeordnete Antriebe (25' und 31) und für die in Y-Richtung orienterte Bewegung ein Antrieb (30') zugeordnet ist, und dass zum Erfassen der in X- und/oder Y-Richtung orientierten Bewegung und zur Parallelitätsmessung sowie zur Betätigung einer Steuerung der Antriebe (25', 30' und 31) entsprechend ausgebildete und damit wirkverbundene Messorgane (42,43,44 ) vorgesehen sind (Fig.2).

4. Einrichtung nach Anspruch 2, dadurch gekennzeichnet, dass die Führungsvorrichtung (50) im wesentlichen ein Führungsteil (51) und ein Schiebeteil (60) umfasst, und dass das Schiebeteil (60) einerseits an einer Stirnseite (61) mit einem orthogonal zur Gleitplatte (15) angeordneten, vakuumvorspannbaren Luftlager (3) mit dem Trägerelement (20) und andererseits mit einem etwa parallel zur Gleitplatte (15) angeordneten, vakuumvorspannbaren Luftlager (2) mit der Gleitplatte (15) wirkverbunden ist (Fig.4).

5. Einrichtung nach Anspruch 4, dadurch gekennzeichnet, dass das Führungsteil (51) zwei in parallelem Abstand zueinander und rechtwinklig zur Gleitplatte (15) angeordnete Stege (53,54) aufweist, zwischen welchen das Schiebeteil (60) mittels einem als Gegendrucklager ausgebildeten Luft-lager (4) in Y-Richtung verschiebbar geführt ist (Fig.4).

6. Einrichtung nach Anspruch 5, dadurch gekennzeichnet, dass das aus den Stegen (53,54) und einem die Stege miteinander verbindenden Flansch (52) gebildete Führungsteil (51) im Profilquerschnitt U-förmig ausgebildet und an den Innenseiten (53',54') der Stege (53,54) mit dem gegen zwei Seitenflächen (60', 60") des Schiebeteils (60) wirkenden Gegendrucklager (4) versehen ist (Fig.4).

7. Einrichtung nach Anspruch 1,2 oder 3, dadurch gekennzeichnet, dass die elektromotorischen Antriebe (25,30,25'; 30',31 oder 32,32') als elektrische Gleichstrom- oder Gleichstrompuls-Linearantriebe ausgebildet sind.

8. Einrichtung nach Anspruch 1 und 7, gekennzeichnet durch die Verwendung elektromotorischer Antriebe (25,30), bei welchen der Statorkörper (28) einen - an sich bekannten - E-förmigen Profilquerschnitt mit im Abstand zueinander angeordneten und an den Innenseiten mit Magnetkörpern versehene Flanschen aufweist, und dass der zwischen den Flanschen in entsprechenden Ausnehmungen (29) in der Ebene frei bewegliche und mit dem Trägerglied (26) wirkverbundene Spulenkörper (27) bei entsprechender Gleichstrom-Erregung derart betätigt wird, dass der etwa kastenrahmenartig ausgebildete und den mittleren, als Pol vorgesehenen Flansch umgreifende Spulenkörper (27) zusammen mit dem Trägerglied (26) in eine erste, entsprechend der Achse des Spulenkörpers (27) orientierte Richtung sowie in eine zweite, im wesentlichen quer dazu orientierte Richtung bewegbar ist.

9. Einrichtung nach Anspruch 1,2 oder 3, dadurch gekennzeichnet, dass das durch eine entsprechende, elektrische Gleichstrom- oder Gleichstrompuls-Erregung bewegte Element des elektromotorischen Antriebs (25,30;25',30',31 oder 32,32') mit dem Trägerelement (20;20') als eine Baueinheit ausgebildet ist, bei welcher Baueinheit die Kraftflussrichtung des bewegten Antriebselements im wesentlichen durch den Schwerpunkt des Trägerelements (20,20') erfolgt.

10. Einrichtung nach einem der Ansprüche 1,2 oder 3, dadurch gekennzeichnet, dass
a) jeder Antrieb (25,30,31) einen feststehend auf einer Grundplatte (10) angeordneten, mit zwei horizontal in parallelem Abstand zueinander angeordneten Schlitzen (29) versehenen Statorkörper (28) sowie ein am Trägerelement (20) angeordnetes, zur Aufnahme eines mit dem Statorkörper (28) in Wirkverbindung stehender Spulenkörper (27) vorgesehenes Trägerglied (26,26') umfasst, und
b) der Spulenkörper (27) mit dem Trägerglied (26,26') bei entsprechender Gleichstrom-Erregung des Spulenkörpers (27) relativ zu dem Statorkörper (28) in eine erste Richtung (X) der und/oder rechtwinklig dazu in eine zweite Richtung (Y) bewegbar ist.

11. Einrichtung nach Anspruch 8 und 9 , dadurch gekennzeichnet, dass das Trägerelement (20 oder 20') mit dem Trägerglied (26 oder 26') und dem jeweiligen Spulenkörper als eine starre Baueinheit ausgebildet ist.

12. Einrichtung nach Anspruch 2 und 4 bis 10, gekennzeichnet durch die Vereinigung folgender Merkmale: dass
a) das mit den elektromotorischen Antrieben (25,30) in Wirkverbindung stehende Trägerelement (20) durch das parallel zur Gleitplatte (15) angeordnete, vakuumvorspannbare Luftlager (1) frei beweglich auf der Gleitplatte (15) angeordnet ist,
b) das Trägerelement (20) mit der einen Seitenwand (24) durch das orthogonal zur Gleitplatte (15) angeordnete, vakuum-vorspannbare Luftlager (3) an der Stirnseite (61) des Schiebeteils (60) in X-Richtung verschiebbar geführt ist,
c) das Schiebeteil (60) durch das parallel zur Gleitplatte (15) angeordnete, vakuumvorspannbare Luftlager (2) auf der Gleitplatte (15) sowie durch das Gegendruck-Luftlager (4) zwischen den beiden Stegen (53,54) des Führungsteils (51) in Y-Richtung verschiebbar geführt ist, und
d) die im wesentlichen mit dem Trägerelement (20) in Wirkverbindung stehende, optronische Mess-Vorrichtung (80) zum Erfassen der in Y- und/oder Y-Richtung orientierten Bewegung des Trägerelements (20) sowie zur Betätigung der Steuerung des entsprechenden Antriebs (25,30) ausgebildet ist (Fig.4).

13. Einrichtung nach Anspruch 2, dadurch gekennzeichnet, dass die optronische Messvorrichtung (80)
a) mindestens ein mit dem Trägerelement (20) wirkverbundenes, mit in X- und Y-Richtung orientierten Stricheinheiten versehenes Messelement (72,72), und
b) auf der dem Messelement (72,73) zugewandten Seite mindestens einen, in bezug auf Messelement (72,73) feststehend an der Gleitplatte (15) angeordneten, optronischen Messkopf (70,71) umfasst, und dass
c) von dem Messkopf (70,71) eine in bezug auf das Trägerelement (20) stellungsabhängige Betätigung der Steuerung der Antriebe (25,30) erfolgt.

14. Einrichtung nach Anspruch 13, dadurch gekennzeichnet, dass das plattenartige Messelement (72,73) in einer der Oberfläche (16) Gleitplatte (15) zugewandten Ausnehmung (18) des Trägerelements (20) und der Messkopf (70,71) in einer dem Trägerelement (20) zugewandten Ausnehmung (17) der Gleitplatte (15) angeordnet sind.

15. Einrichtung nach Anspruch 2, dadurch gekennzeichnet, dass die Führungsvorrichtung (150) ein an einem mit der Gleitplatte (15) fest verbundenen Führungsteil (151) linear geführtes, T-förmig ausgebildetes Schiebeteil (160) umfasst, welches
a) mit dem Flansch (161) durch das vakuumvorspannbare Luft-lager (3) mit dem Trägerelement (20), und
b) mit dem Steg (162) durch ein vakuumvorspannbares Luflager (3) mit der Gleitplatte (15) und dem Führungsteil (151) wirkverbunden ist (Fig.9).

16. Einrichtung nach Anspruch 2, dadurch gekennzeichnet, dass die Führungsvorrichtung (250) ein zwischen zwei im Abstand zueinander auf der Gleitplatte (15) angeordneten Führungsteilen (251,251') gelagertes, etwa T-förmig ausgebildetes Schiebeteil (260) umfasst, welches
a) mit dem Flansch (261) durch das vakuumvorspannbare Luftlager (3) mit dem Trägerelement (20), und
b) mit dem Steg (262) in horizontaler Ebene im Abstand (264) zur Gleitplatte (15) zwischen zwei Führungsteilen (251,251') angeordnet und mittels zwei in entsprechend ausgebildeten Ausnehmungen angeordneten Profilkörper-Kupplungselementen (252,252') gelagert ist, wobei
c) in den Ausnehmungen des Steges (252) jeweils ein auf das entsprechende Kupplungselement (252,252') wirkendes Gegendruck-Luftlager (265,265') vorgesehen ist.

17. Einrichtung nach einem der Ansprüche 1,2 oder 3, gekennzeichnet durch die Verwendung von elektromotorischen Antrieben (25,30 oder 25',30',31), bei welcher Verwendung das Trägerelement (20,20') zusammen mit dem Spulenkörper (27) und dem Trägerglied (26) relativ zu dem feststehend angeordneten Statorkörper (28) in eine erste, mit der Spulenachse etwa gleichsinnig verlaufende Richtung sowie in eine zweite, rechtwinklig dazu orientierte Richtung bewegbar ist.

18. Einrichtung nach einem der Ansprüche 1,2 oder 3, gekennzeichnet durch die Verwendung von elektromotorischen Antrieben, bei welcher Verwendung das Trägerelement (20,20') zusammen mit dem entsprechenden Statorkörper relativ zu einem feststehend angeordneten Trägerglied für den Spulenkörper in eine erste, mit der Spulenachse etwa gleichsinnig verlaufende Richtung sowie in eine zweite, rechtwinklig dazu orientierte Richtung bewegbar ist.

## Claims

1. Device for executing the feed movement of an operating member, in particular of a bonding head constructed as a gripper, to an operating station, having a support element (20, 20') which is constructed to hold the operating member, is arranged on a sliding plate (15, 15'), is operationally connected to at least two drives (25, 30), for example to electric motor drives, and can be adjusted relative to the sliding plate (15, 15') along two coordinates, orientated approximately perpendicular to one another in the plane, in the X-direction and Y-direction, the support element (20, 20') being arranged on the sliding plate (15, 15') in a fashion essentially operationally connected to the moving part of the electric motor drive, capable of moving by means of a sliding bearing, assigned to the sliding plate (15, 15'), in a prescribed, horizontal plane with degrees of translational freedom and a degree of rotational freedom, and largely freely suspended, characterized in that the degree of rotational freedom is achieved perpendicular to the XY-plane by virtue of the fact that the movable parts of the drives and the supporting element (20, 20') can be moved transverse to the respective drive direction (X and Y, respectively) into a second direction (Y and X, respectively) running approximately at right angles, and in that at least one aircushion bearing (1) arranged on the underside (21) facing the sliding plate (15, 15') and formed from a vacuum zone (22) as well as a compressed air zone (23) surrounding the vacuum zone (22) is arranged in a vacuum-prestressed fashion on the sliding plate (15, 15').

2. Device according to Claim 1, characterized in that the support element (20) is operationally connected to a first drive (25) for the movement orientated in the Y-direction, to a second drive (30) for the movement orientated in the X-direction and, on the side opposite the first drive (25), to a guide device (50, 150, 250) and to an optoelectronic measuring device (80) correspondingly assigned to the support element (20), the measuring device (80) being constructed to detect the movement, relative to the sliding plate (15) and orientated in the X-direction and/or Y-direction, of the support element (20) as well as to actuate a controller of the two drives (25, 30) (Figures 1, 12).

3. Device according to Claim 1, characterized in that the support element (20') is assigned two drives (25' and 31), correspondingly arranged relative to one another, for the movement orientated in the X-direction and a drive (30') for the movement orientated in the Y-direction, and in that for the purpose of detecting these movements orientated in the X-direction and/or Y-direction and of measuring parallelism as well as of actuating a controller of the drives (25', 30' and 31) provision is made of measuring elements (42, 43, 44) which are correspondingly constructed and thereby operationally connected (Figure 2).

4. Device according to Claim 2, characterized in that the guide device (50) essentially comprises a guide part (51) and a slide part (60), and in that the slide part (60) is operationally connected, on the one hand, at an end face (61) to the support element (20) by means of a vacuum-prestressed aircushion bearing (3) arranged orthogonally relative to the sliding plate (15), and on the other hand to the sliding plate (15) by means of a vacuum-prestressed aircushion bearing (2) arranged approximately parallel to the sliding plate (15) (Figure 4).

5. Device according to Claim 4, characterized in that the guide part (51) has two webs (53, 54) which are arranged at a parallel spacing from one another and perpendicular to the sliding plate (15) and between which the slide part (60) is guided displaceably in the Y-direction by means of an aircushion bearing (4) constructed as a thrust bearing (Figure 4).

6. Device according to Claim 5, characterized in that the guide part (51), formed from the webs (53, 54) and a flange (52) connecting the webs to one another, is constructed with a U-shaped profile cross-section and is provided on the inner sides (53', 54') of the webs (53 or 54) with the thrust bearing (4) acting against two lateral faces (60', 60") of the slide part (60) (Figure 4).

7. Device according to Claim 1, 2 or 3, characterized in that the electric motor drives (25, 30, 25'; 30', 31 or 32, 32') are constructed as electric DC or pulsed DC linear drives.

8. Device according to Claims 1 and 7, characterized by the use of electric motor drives (25, 30) in which the stator member (28) has an E-shaped profile cross-section - which is known per se - with flanges arranged at a spacing from one another and provided on the inner sides with magnet members, and in that the coil former (27), which can move freely in the plane between the flanges in corresponding cutouts (29) in the plane and is operationally connected to the support element (26), can be actuated, given appropriate DC excitation, in such a way that the coil former (27), which is constructed approximately in the shape of a box-type frame and embracing the middle flange, provided as a pole, can be moved together with the support element (26) in a first direction, orientated in accordance with the axis of the coil former (27), as well as in a second direction, orientated essentially transverse thereto.

9. Device according to Claim 1, 2 or 3, characterized in that the element, moved by an appropriate, electric DC or pulsed DC excitation, of the electric motor drive (25, 30; 25', 30', 31 or 32, 32') is constructed with the support element (20; 20') as a unit in which the direction of the force lines of the moving drive element essentially extends through the centroid of the support element (20, 20').

10. Device according to one of Claims 1, 2 or 3, characterized in that
a) each drive (25, 30, 31) comprises a fixed stator member (28) which is arranged on a base plate (10) and provided with two slots (29) arranged horizontally at a parallel spacing from one another, as well as a support member (26, 26') arranged on the support element (20) and provided for holding a coil former (27) operationally connected to the stator member (28), and in that
b) given appropriate DC excitation of the coil former (27), the coil former, (27) can be moved with the support member (26, 26') relative to the stator member (28) in the first direction (X) and/or in the second direction (Y) perpendicular thereto.

11. Device according to Claims 8 and 9, characterized in that the support element (20 or 20') is constructed as a rigid unit together with the support member (26 or 26') and the respective coil former.

12. Device according to Claims 2 and 4 to 10, characterized by the combination of the following features:
a) the support element (20) operationally connected to the electric motor drives (25, 30) is arranged in a freely movable fashion on the sliding plate (15) by means of the vacuum-prestressable aircushion bearing (1) arranged parallel to the sliding plate (15),
b) the support element (20) is guided displaceably in the X-direction with one side wall (24) at the end face (61) of the slide part (60) by means of the vacuum-prestressable aircushion bearing (3) arranged orthogonal to the sliding plate (15),
c) the slide part (60) is guided displaceably in the Y-direction between the two webs (53, 54) of the guide part (51) by means of the vacuum-prestressable aircushion bearing (2), arranged parallel to the sliding plate (15), as well as by means of the aircushion thrust bearing (4), and
d) the optoelectronic measuring device (80), which is essentially operationally connected to the support element (20), is constructed for the purpose of detecting the movement, orientated in the X-direction and/or Y-direction, of the support element (20) as well as of actuating the controller of the corresponding drive (25, 30) (Figure 4).

13. Device according to Claim 2, characterized in that the optoelectronic measuring device (80) comprises
a) at least one measuring element (72, 73) operationally connected to the support element (20) and provided with bar units orientated in the X-direction and Y-direction, and
b) on the side facing the measuring element (72, 73), at least one optoelectronic measuring head (70, 71) arranged on the sliding plate (15) in a fashion fixed with respect to the measuring element (72, 73), and in that
c) the measuring head (70, 71) actuates the controller of the drives (25, 30) as a function of position with respect to the support element (20).

14. Device according to Claim 13, characterized in that the plate-like measuring element (72, 73) is arranged in a cutout (18) of the support element (20) which faces the surface (16) of the sliding plate (15), and the measuring head (70, 71) is arranged in a cutout (17) of the sliding plate (15) which faces the support element (20).

15. Device according to Claim 2, characterized in that the guide device (150) comprises a slide part (160) which is constructed in the shape of a T and is guided linearly on a guide part (151) firmly connected to the sliding plate (15), and which is operationally connected
a) with the flange (161) by means of the vacuum-prestressable aircushion bearing (3) to the support element (20), and
b) with the web (162) by means of a vacuum-prestressable aircushion bearing (3) to the sliding plate (15) and the guide part (151) (Figure 9).

16. Device according to Claim 2, characterized in that the guide device (250) comprises a slide part (260) which is constructed approximately in the shape of a T and is mounted between two guide parts (251, 251') arranged at a spacing from one another on the sliding plate (15), and which
a) is operationally connected with the flange (261) by means of the aircushion bearing (3) to the support element (20), and
b) is arranged with the web (262) in a horizontal plane at a spacing (264) from the sliding plate (15) between two guide parts (251, 251') and is mounted by means of two profile member coupling elements (252, 252') arranged in correspondingly constructed cutouts,
c) there being respectively provided in the cutouts in the web (262) an aircushion thrust bearing (265, 265') acting on the corresponding coupling element (252, 252').

17. Device according to one of Claims 1, 2 or 3, characterized by the use of electric motor drives (25, 30 or 25', 30', 31), in the case of which use the support element (20, 20') can be moved together with the coil former (27) and the support member (26) relative to the fixedly arranged stator member (28) in a first direction, running approximately in the same sense as the coil axis, and in a second direction orientated perpendicular thereto.

18. Device according to one of Claims 1, 2 or 3, characterized by the use of electric motor drives, in the case of which use the support element (20, 20') can be moved together with the corresponding stator element relative to a fixedly arranged support member for the coil former in a first direction, running approximately in the same sense as the coil axis, as well as in a second direction orientated perpendicular thereto.

## Revendications

1. Mécanisme pour la mise en oeuvre du mouvement d'avance d'un organe de travail, en particulier d'une tête d'assemblage réalisée sous forme d'élément de préhension, en direction d'un poste de travail, comprenant un élément de support (20, 20') réalisé pour que vienne s'y loger l'organe de travail et disposé sur une plaque de coulissement (15, 15'), qui est relié en entraînement avec au moins deux commandes (25, 30), par exemple avec des commandes par moteurs électriques, et qui est apte à se déplacer par rapport à la plaque de coulissement (15, 15') le long de deux coordonnées dans les directions X et Y, orientées dans le plan de manière approximativement perpendiculaire l'une par rapport à l'autre, dans lequel l'élément de support (20, 20') est relié en entraînement essentiellement avec la partie mobile de la commande par moteur électrique et est disposé, au moyen d'un palier à coulissement attribué à la plaque de coulissement (15, 15'), en mobilité dans un plan horizontal préréglé, avec des degrés de liberté de translation et un degré de liberté de rotation, et en suspension à liberté étendue contre la plaque de coulissement (15, 15'), caractérisé en ce qu'on obtient le degré de liberté de rotation perpendiculairement au plan X-Y par le fait que les parties mobiles des commandes et l'élément de support (20, 20') sont mobiles transversalement à la direction respective de la commande (X, respectivement Y) dans une seconde direction s'étendant approximativement à angle droit (Y, respectivement X), et en ce qu'au moins un palier à coussin pneumatique (1), disposé contre le côté inférieur (21) tourné vers la plaque de coulissement (15, 15') et constitué par une zone de vide (22) et par une zone d'air comprimé (23) entourant la zone de vide (22), est mis en état de précontrainte grâce au vide sur la plaque de coulissement (15, 15').

2. Mécanisme selon la revendication 1, caractérisé en ce que l'élément de support (20) est relié en entraînement avec une première commande (25) pour le mouvement orienté dans la direction Y, avec une seconde commande (30) pour le mouvement orienté dans la direction X et, sur le côté opposé à la première commande (25), avec un dispositif de guidage (50, 150, 250), ainsi qu'avec un dispositif de mesure du type à optique électronique (80) attribué de manière correspondante à l'élément de support (20), dans lequel le dispositif de mesure (80) est réalisé pour enregistrer le mouvement de l'élément de support (20) orienté dans les directions X et/ou Y par rapport à la plaque de coulissement (15), ainsi que pour la mise en oeuvre d'un réglage automatique des deux commandes (25, 30) (figures 1, 12).

3. Mécanisme selon la revendication 1, caractérisé en ce que, sont attribuées à l'élément de support (20'), pour le mouvement orienté dans la direction X, deux commandes (25' et 31) disposées en correspondance mutuelle et, pour le mouvement orienté dans la direction Y, une commande (30'), et en ce que, pour l'enregistrement du mouvement orienté dans les directions X et/ou Y et pour la mesure du parallélisme, ainsi que pour la mise en oeuvre d'un réglage automatique des commandes (25', 30' et 31), sont prévus des organes de mesure (42, 43, 44) réalisés de manière correspondante, partant reliés en entraînement.

4. Mécanisme selon la revendication 2, caractérisé en ce que le dispositif de guidage (50) comprend essentiellement une partie de guidage (51) et une partie coulissante (60), et en ce que la partie coulissante (60) est reliée en entraînement, d'une part, sur son côté frontal (61), à l'aide d'un palier d'air (3) qui peut être mis en état de précontrainte grâce au vide et qui est monté en position orthogonale par rapport à la plaque de coulissement (15), avec l'élément de support (20) et, d'autre part, à l'aide d'un palier d'air (2) qui peut être mis en état de précontrainte grâce au vide et qui est disposé approximativement parallèlement à la plaque de coulissement (15), avec la plaque de coulissement (15) (figure 4).

5. Mécanisme selon la revendication 4, caractérisé en ce que la partie de guidage (51) présente deux traverses (53, 54) disposées en écartement parallèle l'une par rapport à l'autre et perpendiculairement à la plaque de coulissement (15), traverses entre lesquelles la partie coulissante (60) est guidée en coulissement dans la direction Y au moyen d'un palier d'air (4) réalisé sous forme de palier à contre-pression (figure 4).

6. Mécanisme selon la revendication 5, caractérisé en ce que la partie de guidage (51), constituée par des traverses (53, 54) et par une bride (52) reliant les traverses l'une à l'autre, est réalisée en forme de U dans sa section transversale profilée et est munie, sur les côtés internes (53', 54') des traverses (53, 54), du palier à contre-pression (4) agissant contre deux surfaces latérales (60', 60") de la partie coulissante (60) (figure 4).

7. Mécanisme selon la revendication 1, 2 ou 3, caractérisé en ce que les commandes par moteurs électriques (25, 30, 25'; 30', 31 ou 32, 32') sont réalisées sous forme de commandes linéaires électriques à courant continu ou à impulsions à courant continu.

8. Mécanisme selon les revendications 1 et 7, caractérisé par l'utilisation de commandes par moteurs électriques (25, 30), dans lesquelles le corps de stator (28) présente une section transversale profilée en forme de E - connue en soi - comprenant des brides disposées à distance l'une de l'autre et munies de corps magnétiques sur leurs côtés internes, et en ce que l'armature de bobine (27), librement mobile dans le plan entre les brides dans des évidements correspondants (29) et reliée en entraînement à l'organe de support (26), est entraînée via une excitation de courant continu correspondante par le fait que l'armature de bobine (27), réalisée approximativement en forme de caisse-poutre et enserrant la bride médiane prévue pour servir de pôle, est mobile conjointement avec l'organe de support (26) dans une première direction orientée par rapport à l'axe de l'armature de bobine (27), ainsi que dans une seconde direction orientée essentiellement transversalement à la première.

9. Mécanisme selon la revendication 1, 2 ou 3, caractérisé en ce que l'élément de commande par moteur électrique (25, 30; 25', 30', 31 ou 32, 32'), mis en mouvement via une excitation électrique correspondante à courant continu ou à impulsions de courant continu, est réalisé sous forme d'unité modulaire avec l'élément de support (20, 20'), unité modulaire dans laquelle la direction du flux magnétique de l'élément de commande mis en mouvement passe essentiellement par le centre de gravité de l'élément de support (20, 20').

10. Mécanisme selon l'une quelconque des revendications 1, 2 ou 3, caractérisé en ce que
a) chaque commande (25, 30, 31) comprend un corps de stator (28) disposé à demeure sur une plaque de base (10) et muni de deux fentes (29) disposées horizontalement en écartement parallèle l'une par rapport à l'autre, ainsi qu'un organe de support (26, 26') disposé sur l'élément de support (20) et prévu pour que vienne s'y loger une armature de bobine (27) se trouvant en liaison d'entraînement avec le corps de stator (28), et
b) l'armature de bobine (27) peut se déplacer avec l'organe de support (26, 26'), lors d'une excitation correspondante à courant continu de l'armature de bobine (27), par rapport au corps de stator (28), dans une première direction X et/ou perpendiculairement à cette dernière dans une seconde direction Y.

11. Mécanisme selon les revendications 8 et 9, caractérisé en ce que l'élément de support (20 ou 20') est réalisé sous forme d'une unité modulaire fixe avec l'organe de support (26 ou 26') et l'armature de bobine respective.

12. Mécanisme selon la revendication 2 et selon les revendications 4 à 10, caractérisé par la combinaison des caractéristiques ci-après:
a) l'élément de support (20) en liaison d'entraînement avec les commandes par moteurs électriques (25, 30) est disposé en mobilité libre sur la plaque de coulissement (15) à travers le palier d'air (1) qui peut être mis en état de précontrainte grâce au vide et qui est disposé parallèlement à la plaque de coulissement (15),
b) l'élément de support (20) avec sa première paroi latérale (24) est guidé en coulissement dans la direction X sur le côté frontal (61) de la partie coulissante (60) à travers le palier d'air (3) qui peut être mis en état de précontrainte grâce au vide et qui est monté en position orthogonale par rapport à la plaque de coulissement (15),
c) la partie coulissante (60) est guidée en coulissement dans la direction Y sur la plaque de coulissement (15) à travers le palier d'air (2) qui peut être mis en état de précontrainte grâce au vide et qui est disposé parallèlement à la plaque de coulissement (15), ainsi qu'à travers le palier d'air (4) à contre-pression, entre les deux traverses (53, 54) de la partie de guidage (51), et
d) le dispositif de mesure du type à optique électronique (80) en liaison d'entraînement essentiellement avec l'élément de support (20) est réalisé pour enregistrer le mouvement de l'élément de support (20) dans la direction X et/ou dans la direction Y, ainsi que pour la mise en oeuvre du réglage automatique de la commande correspondante (25, 30) (figure 4).

13. Mécanisme selon la revendication 2, caractérisé en ce que le dispositif de mesure du type à optique électronique (80) comprend:
a) au moins un élément de mesure (72, 73) relié en entraînement avec l'élément de support (20) et muni d'unités en forme de barres orientées dans la direction X et dans la direction Y, et
b) sur le côté tourné vers l'élément de mesure (72, 73), au moins une tête de mesure du type à optique électronique (70, 71) disposée contre la plaque de coulissement (15) à demeure par rapport à l'élément de mesure (72, 73), et en ce que
c) à partir de la tête de mesure (70, 71), a lieu une mise en oeuvre du réglage automatique des commandes (25, 30), en fonction de sa position par rapport à l'élément de support (20).

14. Mécanisme selon la revendication 13, caractérisé en ce que l'élément de mesure (72, 73) en forme de plaque est disposé dans un évidement (18) pratiqué dans l'élément de support (20) et tourné vers la surface (16) de la plaque de coulissement (15) et la tête de mesure (70, 71) est disposée dans un évidement (17) pratiqué dans la plaque de coulissement (15) et tourné vers l'élément de support (20).

15. Mécanisme selon la revendication 2, caractérisé en ce que le dispositif de guidage (150) comprend une partie coulissante (160) réalisée en forme de T et guidée de manière linéaire contre une partie de guidage (151) reliée à demeure à la plaque de coulissement (15), partie coulissante qui est reliée en entraînement
a) à l'aide de la bride (161) à travers le palier d'air (3) qui peut être mis en état de précontrainte grâce au vide, avec l'élément de support (20), et
b) à l'aide de la traverse (162), à travers un palier d'air (3) qui peut être mis en état de précontrainte grâce au vide, avec la plaque de coulissement (15) et avec la partie de guidage (151) (figure 9).

16. Mécanisme selon la revendication 2, caractérisé en ce que le dispositif de guidage (250) comprend une partie coulissante (260) réalisée approximativement en forme de T et montée entre deux parties de guidage (251, 251') disposées à distance l'une de l'autre sur la plaque de coulissement (15), partie coulissante qui
a) est reliée en entraînement à l'aide de la bride (261) à travers le palier d'air (3) qui peut être mis en état de précontrainte grâce au vide, avec l'élément de support (20), et
b) est disposée, à l'aide de la traverse (262), dans un plan horizontal à une certaine distance (264) de la plaque de coulissement (15) entre deux parties de guidage (251, 251') et est montée au moyen de deux éléments d'accouplement à corps profilé (252, 252') disposés dans des évidements réalisés de manière correspondante,
c) un palier d'air à contre-pression respectif (265, 265') agissant sur l'élément d'accouplement correspondant (252, 252') étant prévu dans les évidements pratiqués dans la traverse (262).

17. Mécanisme selon l'une quelconque des revendications 1, 2 ou 3, caractérisé par l'utilisation de commandes par moteurs électriques (25, 30 ou 25', 30', 31), utilisation dans laquelle l'élément de support (20, 20') peut se déplacer, conjointement avec l'armature de bobine (27) et l'organe de support (26), par rapport au corps de stator (28) disposé à demeure, dans une première direction s'étendant approximativement dans le même sens que l'axe de la bobine, ainsi que dans une seconde direction orientée perpendiculairement à cette dernière.

18. Mécanisme selon l'une quelconque des revendications 1, 2 ou 3, caractérisé par l'utilisation de commandes par moteurs électriques, utilisation dans laquelle l'élément de support (20, 20') peut se déplacer conjointement avec le corps de stator correspondant par rapport à un organe de support disposé à demeure, destiné à l'armature de bobine, dans une première direction s'étendant approximativement dans le même sens que l'axe de la bobine, ainsi que dans une seconde direction orientée perpendiculairement à cette dernière.
